(19) Europäisches Patentamt
European Patent Office
Office européen des brevets

(11) EP 4 625 006 A1

(12) **EUROPEAN PATENT APPLICATION**
published in accordance with Art. 153(4) EPC

(43) Date of publication:
**01.10.2025 Bulletin 2025/40**

(21) Application number: **23901083.8**

(22) Date of filing: **06.12.2023**

(51) International Patent Classification (IPC):
***G02B 5/30*** *(2006.01)* ***G02B 1/14*** *(2015.01)*
***G02B 1/18*** *(2015.01)* ***G02B 1/11*** *(2015.01)*
***H10K 59/50*** *(2023.01)* ***B29C 55/04*** *(2006.01)*
***G02F 1/1335*** *(2006.01)*

(52) Cooperative Patent Classification (CPC):
**B29C 55/04; G02B 1/11; G02B 1/14; G02B 1/18; G02B 5/30; G02F 1/1335; H10K 59/50**

(86) International application number:
**PCT/KR2023/019967**

(87) International publication number:
**WO 2024/123065 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.12.2022 KR 20220170358**

(71) Applicant: **SAMSUNG SDI CO., LTD.**
**Yongin-si, Gyeonggi-do 17084 (KR)**

(72) Inventors:
- **YOU, Jung Hun**
**Suwon-si Gyeonggi-do 16678 (KR)**
- **KIM, Bong Choon**
**Suwon-si Gyeonggi-do 16678 (KR)**
- **LEE, Sang Hum**
**Suwon-si Gyeonggi-do 16678 (KR)**
- **KOO, Jun Mo**
**Suwon-si Gyeonggi-do 16678 (KR)**
- **SHIN, Kwang Ho**
**Suwon-si Gyeonggi-do 16678 (KR)**

(74) Representative: **Michalski Hüttermann & Partner Patentanwälte mbB**
**Kaistraße 16A**
**40221 Düsseldorf (DE)**

(54) **POLARIZING PLATE AND OPTICAL DISPLAY DEVICE**

(57) Provided are a polarizing plate and an optical display device comprising same, wherein the polarizing plate comprises: a polarizer; and a phase retardation layer laminated on a lower surface of the polarizer, the phase retardation layer including a negative C layer, a negative A layer, and a positive A layer, which are sequentially laminated from the lower surface of the polarizer, wherein the negative C layer has a thickness-dependent phase retardation of 20 nm to 60 nm at a wavelength of 550 nm.

**FIG. 1**

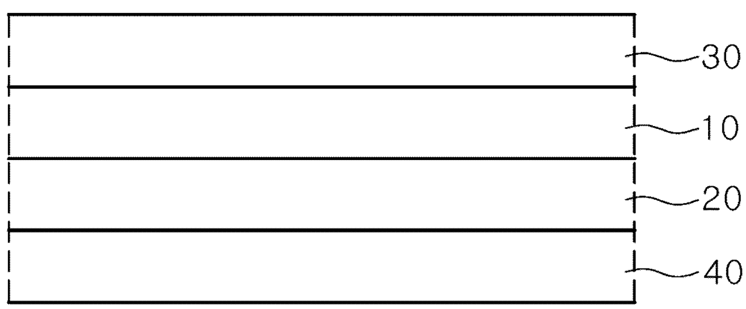




EP 4 625 006 A1

## Description

[Technical Field]

The present invention relates to a polarizing plate and an optical display apparatus.

[Background Art]

An organic light emitting diode display can have a problem of deterioration in visibility and contrast due to reflection of external light. To solve this problem, the organic light emitting diode display adopts a polarizing plate. The polarizing plate can realize an antireflection function through reduction in reflectivity with respect to reflected external light. The polarizing plate generally requires remarkable improvement in screen quality through improvement in black visibility at a front side.

The polarizing plate includes a polarizer and an antireflection layer stacked on a lower surface of the polarizer. The antireflection layer may be a single sheet-type retardation layer or a double sheet-type retardation layer. The single sheet-type retardation layer generally realizes negative wavelength dispersion characteristics. The double sheet-type retardation layer generally realizes negative wavelength dispersion characteristics through lamination of retardation layers each having positive wavelength dispersion characteristics. Although the double sheet-type retardation layer can have a larger thickness than the single sheet-type retardation layer, the double sheet-type retardation layer may be formed by stacking retardation layers having a lower price than the single sheet-type retardation layer and exhibiting positive wavelength dispersion characteristics to secure price competitiveness and improvement in productivity.

The retardation layer may be formed by stretching a non-stretched film formed of a polymer resin-containing composition or by coating a liquid crystal composition to a predetermined thickness on an alignment layer, followed by drying and/or curing. Although a retardation layer composed of double sheets of liquid crystals has a smaller thickness than a retardation layer composed of double sheets of stretched films, the retardation layer composed of the double sheets of liquid crystals can cause deterioration in durability of a panel through corrosion of an electrode due to iodine eluted from the polarizer and diffused into the panel when the polarizing plate is left under high temperature/humidity conditions. Although a method of fundamentally preventing iodine elution from the polarizer can be used, this method has a limit in practice.

The background technique of the present invention is disclosed in Korean Patent Laid-open Publication No. 10-2013-0103595.

[Disclosure]

[Technical Problem]

It is one object of the present invention to provide a polarizing plate that has very low reflectivity at a lateral side while realizing good black visibility.

It is another object of the present invention to provide a polarizing plate that can minimize contamination of a liquid crystal layer and/or a panel due to iodine eluted from a polarizer when left under high temperature/humidity conditions for a long period of time.

It is a further object of the present invention to provide a polarizing plate that can achieve thickness reduction.

[Technical Solution]

One aspect of the present invention relates to a polarizing plate.

1. The polarizing plate includes: a polarizer; and retardation layers stacked on a lower surface of the polarizer, wherein the retardation layers include a negative C layer, a negative A layer and a positive A layer sequentially stacked on the lower surface of the polarizer, and the negative C layer has an out-of-plane retardation of 20 nm to 60 nm at a wavelength of 550 nm.
2. In 1, the negative C layer may have a front in-plane retardation of 0 nm to 10 nm at a wavelength of 550 nm.
3. In 1 to 2, the negative C layer may have a ratio of 0.0005 nm/nm to 0.003 nm/nm, as calculated according to Equation 1:

[Equation 1]

$$A / B,$$

where A is an out-of-plane retardation (unit: nm) of the negative C layer at a wavelength of 550 nm and B is a thickness (unit: nm) of the negative C layer.

4. In 1 to 3, the negative C layer may have a water vapor transmission rate of 400 $g/m^2 \cdot day$ or less.

5. In 1 to 4, the negative C layer may be a film or coating layer including a polymer exhibiting positive inherent birefringence.

6. In 1 to 5, the negative C layer may be a film or coating layer of a triacetylcellulose (TAC), cyclic olefin polymer (COP) or cyclic olefin copolymer (COC) resin.

7. In 1 to 6, a thickness ratio of a laminate of the negative C layer, the negative A layer and the positive A layer to the retardation layers may be 95% or more.

8. In 1 to 7, a laminate of the negative A layer and the positive A layer may have negative wavelength dispersion characteristics.

9. In 1 to 8, the laminate of the negative A layer and the positive A layer may have a linear retardation of 120 nm to 180 nm at a wavelength of 550 nm.

10. In 1 to 9, the positive A layer may have a lower front in-plane retardation at a wavelength of 550 nm than the negative A layer.

11. In 10, the positive A layer may have a front in-plane retardation of 100 nm to 140 nm at a wavelength of 550 nm and the negative A layer may have a front in-plane retardation of 200 nm to 280 nm at a wavelength of 550 nm.

12. In 1 to 11, a slow axis of the positive A layer may be slanted at an angle of 55° to 65° with respect to a slow axis of the negative A layer.

13. In 1 to 12, the slow axis of the positive A layer may be slanted at an angle of 70° to 85° with respect to a light transmission axis of the polarizer and the slow axis of the negative A layer may be slanted at an angle of 10° to 25° with respect to the light transmission axis of the polarizer.

14. In 1 to 13, each of the positive A layer and the negative A layer may be a liquid crystal layer.

15. In 14, the positive A layer may be a nematic liquid crystal layer and the negative A layer may be a discotic liquid crystal layer.

16. In 1 to 15, the polarizing plate may further include a second protective layer stacked on an upper surface of the polarizer.

Another aspect of the present invention relates to an optical display apparatus.

The optical display apparatus includes the polarizing plate according to the present invention.

[Advantageous Effects]

The present invention provides a polarizing plate that has very low reflectivity at a lateral side while realizing good black visibility at the lateral side.

The present invention provides a polarizing plate that can minimize contamination of a liquid crystal layer and/or a panel due to iodine eluted from a polarizer when left under high temperature/humidity conditions for a long period of time.

The present invention provides a polarizing plate that can achieve thickness reduction.

[Description of Drawings]

FIG. 1 is a sectional view of a polarizing plate according to one embodiment of the present invention.

FIG. 2 is a sectional view of a polarizing plate according to another embodiment of the present invention.

FIG. 3 is a graph depicting the maximum reflectivity (Y axis, unit: %) at a lateral side (60°) according to Rth of a negative C layer (X axis, unit: nm).

[Best Mode]

Hereinafter, embodiments of the present invention will be described in detail with reference to the accompanying drawings such that the present invention can be easily implemented by those skilled in the art. It should be understood that the present invention may be embodied in different ways and is not limited to the following embodiments.

The terminology used herein is for the purpose of describing exemplary embodiments and is not intended to limit

the scope of the invention. Herein, the singular forms "a," "an," and "the" are intended to include the plural forms as well, unless the context clearly indicates otherwise.

In the drawings, portions irrelevant to the description will be omitted for clarity. Like components will be denoted by like reference numerals throughout the specification. Although lengths, thicknesses or widths of various components may be exaggerated in the drawings for description of the invention, the present invention is not limited thereto

Herein, spatially relative terms such as "upper" and "lower" are defined with reference to the accompanying drawings. Thus, it will be understood that "upper surface" can be used interchangeably with "lower surface".

Herein, "front in-plane retardation (Re)", "out-of-plane retardation (Rth)", and "degree of biaxiality (NZ)" are represented by Equations A, B and C, respectively:

[Equations A]

$$Re = (nx - ny) \times d$$

[Equations B]

$$Rth = ((nx + ny)/2 - nz) \times d,$$

[Equations C]

$$NZ = (nx - nz)/(nx - ny)$$

where nx, ny, and nz are indexes of refraction of a retardation layer in a slow axis direction, a fast axis direction and a thickness direction thereof at a measurement wavelength, respectively, and d denotes a thickness of the retardation layer (unit: nm).

Unless specified otherwise, nx, ny, and nz indicate the indexes of refraction of the retardation layer in the slow axis direction, the fast axis direction and the thickness direction thereof at a wavelength of 550 nm, respectively. Herein, the slow axis is defined as an axis providing the highest index of refraction in an in-plane direction and the fast axis is defined as an axis providing the lowest index of refraction in the in-plane direction. The slow axis may be substantially orthogonal to the fast axis, without being limited thereto.

Herein, "reflectivity" refers to a value excluding the primary reflectivity at the outermost region and calculated based on an assumption that an OLED bare panel (OLED panel having no polarizing plate therein) has a reflectivity of 100%.

Herein, "water vapor transmission rate (WVTR)" may be measured by a typical method known to those skilled in the art and means a value measured, for example, at 23°C and at 99% RH (relative humidity) to 100% RH. The water vapor transmission rate may be measured using a water vapor transmission rate meter (PERMATRAN-W, MODEL 700), without being limited thereto. A sample for measurement of the water vapor transmission rate may be prepared by cutting, for example, a negative C layer into a size of 10 cm x 10 cm (length x width).

The present invention provides a polarizing plate capable of realizing very low reflectivity and good black visibility at a lateral side when attached to a panel including an organic light emitting diode, an inorganic light emitting diode or an organic/inorganic light emitting diode. The present invention provides an antireflection polarizing plate that realizes a maximum reflectivity of less than 2.5% at a lateral side, for example, at a lateral viewing angle of 60°.

The present invention provides a polarizing plate that minimizes contamination of a liquid crystal layer and/or a panel due to iodine eluted from a polarizer when left under high temperature/humidity conditions for a long period of time. The retardation layer includes a liquid crystal layer, which has a thinner layer than a film. For the retardation layer including the liquid crystal layer between the polarizer and the panel, iodine can be eluted from the polarizer and can contaminate the liquid crystal layer and the panel when the polarizing plate is left under high temperature/humidity conditions for a long period of time. When iodine contaminates the liquid crystal layer and the panel, screen quality can be deteriorated due to a color (for example, violet) of iodine.

The present invention improves durability of the polarizing plate by solving such problems. Here, "elution of iodine" may be evaluated based on a color change indicating the degree of iodine elution determined by observing a periphery of the polarizing plate through a microscope after the polarizing plate is left in a chamber under high temperature and high humidity (60°C and 90% relative humidity) conditions for 250 hours.

The present invention provides a polarizing plate including a thin retardation layer to reduce the thickness of the polarizing plate. In one embodiment, the retardation layer of the polarizing plate may have a thickness of 20 μm to 100 μm, for example, 20 μm, 25 μm, 30 μm, 35 μm, 40 μm, 45 μm, 50 μm, 55 μm, 60 μm, 65 μm, 70 μm, 75 μm, 80 μm, 85 μm, 90 μm, 95 μm, or 100 μm, preferably 20 to 90 μm, more preferably 20 μm to 85 μm. Within this range, the polarizing plate can

achieve thickness reduction.

The polarizing plate according to the present invention may include: a polarizer; and retardation layers stacked on a lower surface of the polarizer, wherein the retardation layers include a negative C layer, a negative A layer and a positive A layer sequentially stacked on the lower surface of the polarizer, and the negative C layer has an out-of-plane retardation of 20 nm to 60 nm at a wavelength of 550 nm.

In one embodiment, the retardation layers may be a laminate of three retardation layers of the negative C layer, the negative A layer, and the positive A layer.

According to the present invention, the negative A layer and the positive A layer are sequentially stacked as the retardation layers on the lower surface of the polarizer, and the negative C layer is further stacked between the polarizer and the negative A layer, in which the out-of-plane retardation of the negative C layer at a wavelength of 550 nm is adjusted to a particular range of 20 nm to 60 nm, whereby the polarizing plate can easily achieve a maximum reflectivity of less than 2.5% at a lateral side.

For the polarizing plate according to the present invention, in which the negative C layer is disposed between the positive A layer and the negative A layer or disposed on a lower surface of the positive A layer, it can be difficult to achieve a maximum reflectivity of less than 2.5% at the lateral side.

For the polarizing plate according to the present invention, where the negative C layer has an out-of-plane retardation of less than 20 nm at a wavelength of 550 nm, it can be difficult to achieve a maximum reflectivity of less than 2.5% at the lateral side and the thickness of the negative C layer becomes too thin, thereby causing iodine contamination of the polarizing plate and/or a panel when the polarizing plate is left under high temperature/humidity conditions for a long period of time. For the polarizing plate according to the present invention, in which the negative C layer has an out-of-plane retardation of greater than 60 nm at a wavelength of 550 nm, it can be difficult to achieve a maximum reflectivity of less than 2.5% at the lateral side and to achieve thickness reduction. In one embodiment, the negative C layer may have an out-of-plane retardation of 20 nm, 21 nm, 22 nm, 23 nm, 24 nm, 25 nm, 26 nm, 27 nm, 28 nm, 29 nm, 30 nm, 31 nm, 32 nm, 33 nm, 34 nm, 35 nm, 36 nm, 37 nm, 38 nm, 39 nm, 40 nm, 41 nm, 42 nm, 43 nm, 44 nm, 45 nm, 46 nm, 47 nm, 48 nm, 49 nm, 50 nm, 51 nm, 52 nm, 53 nm, 54 nm, 55 nm, 56 nm, 57 nm, 58 nm, 59 nm, or 60 nm, preferably 30 nm to 40 nm, at a wavelength of 550 nm.

Hereinafter, each component of the polarizing plate according to the present invention will be described in detail.

## Polarizer

The polarizer serves to convert natural light or polarized light into linearly polarized light through linear polarization in a certain direction and may be fabricated from a polymer film mainly consisting of a polyvinyl alcohol resin. Specifically, the polarizer may be fabricated by dyeing the polymer film with iodine or dichroic dyes, followed by stretching the dyed film in a machine direction (MD) thereof. In one embodiment, the polarizer may be fabricated through swelling, dyeing, stretching, and, optionally, color correction and/or crosslinking.

The polarizer has a light absorption axis and a light transmission axis in an in-plane direction thereof, in which the light absorption axis may correspond to the machine direction (MD) of the polarizer and the light transmission axis may correspond to the transverse direction (TD) of the polarizer.

The polarizer may have a total light transmittance of 40% or more, for example, 40% to 46%, and a degree of polarization of 95% or more, for example, 95% to 99.999%. Within this range, the polarizer can improve antireflection efficiency in combination with the retardation layer. Here, "light transmittance" and "degree of polarization" are values measured at a wavelength of 380 nm to 780 nm and correspond to visibility in the corresponding wavelength range.

The polarizer may have a thickness of 2 μm to 30 μm, specifically 4 μm to 25 μm. Within this range, the polarizer can be applied to the polarizing plate.

The polarizer may be directly stacked on the negative C layer without an adhesive layer or a bonding layer, or stacked thereon via the adhesive layer or the bonding layer.

## Positive A layer and negative A layer

A laminate of the positive A layer and the negative A layer can assist in achieving a maximum reflectivity of less than 2.5% at the lateral side. However, the polarizing plate cannot achieve a maximum reflectivity of less than 2.5% at the lateral side only through the laminate of the positive A layer and the negative A layer.

The laminate of the positive A layer and the negative A layer is stacked on the lower surface of the polarizer. The polarizing plate may include the negative A layer and the positive A layer sequentially stacked on the polarizer, whereby the effect of the present invention can be easily realized.

The laminate may exhibit negative wavelength dispersion characteristics. As a result, the polarizing plate can easily reach a maximum reflectivity of less than 2.5% at the lateral side. Here, the negative wavelength dispersion characteristics mean that the laminate satisfies relations: Re(450) < Re(550) and Re(550) < Re(650). Here, Re(450),

Re(550), and Re(650) are linear retardation values of the laminate at wavelengths of 450 nm, 550 nm, and 650 nm, respectively.

In one embodiment, the laminate may have a Re(450)/Re(550) value of less than 1, for example, 0.8 to less than 1. The laminate may have a Re(650)/Re(550) value of greater than 1, for example, greater than 1 to 1.2. Within this range, the polarizing plate can easily achieve the negative wavelength dispersion characteristics.

For example, the laminate of the positive A layer and the negative A layer may have a retardation of 110 nm to 170 nm, preferably 120 nm to 160 nm, at a wavelength of 450 nm, a retardation of 120 nm to 180 nm, preferably 130 nm to 170 nm, at a wavelength of 550 nm, and a retardation of 130 nm to 190 nm, preferably 140 nm to 180 nm, at a wavelength of 650 nm. Within this range, the polarizing plate can easily achieve the negative wavelength dispersion characteristics.

Specifically, retardation of the "laminate of retardation layers" is expressed by a linear retardation value calculated according to a Mueller Matrix of the laminate of retardation layers. Herein, the Mueller Matrix of the laminate of retardation layers is expressed by the following equation D and can be easily measured using a retardation meter, for example, an AxoScan.

[Equation D]

$$\begin{bmatrix} 1 & 0 & 0 & 0 \\ 0 & m_{11} & m_{12} & m_{13} \\ 0 & m_{21} & m_{22} & m_{23} \\ 0 & m_{31} & m_{32} & m_{33} \end{bmatrix}$$

Herein, "linear retardation ($R_L$)" is expressed by Equation E and is well known to those skilled in the art. The linear retardation can be easily measured using a retardation meter, for example, an AxoScan.

[Equation E]

$$R_L = \sqrt{(a_1 \times R_T)^2 + (a_2 \times R_T)^2}$$

$$a_1 = \frac{1}{2\sin R_T}(m_{23} - m_{32}) \qquad a_2 = \frac{1}{2\sin R_T}(m_{31} - m_{13})$$

$$R_T = \cos^{-1}\left(\frac{1 + m_{11} + m_{22} + m_{33}}{2}\right)$$

(In Equation E, $m_{23}$, $m_{32}$, $m_{31}$, $m_{13}$, $m_{11}$, $m_{22}$, and $m_{33}$ are obtained from Equation D.)

In Equations D and E, the measurement wavelength may be 450 nm, 550 nm, or 650 nm.

The positive A layer is a retardation layer satisfying a refractivity relation: $nx > ny \fallingdotseq nz$. The positive A layer may have a lower front in-plane retardation at a wavelength of 550 nm than the negative A layer. As a result, the polarizing plate can easily achieve the effects of the present invention.

In one embodiment, the positive A layer may have a front in-plane retardation of 100 nm to 140 nm at a wavelength of 550 nm. Within this range, the positive A layer allows the polarizing plate to easily achieve a maximum reflectivity of less than 2.5% at the lateral side together with the negative A layer and the negative C. For example, the positive A layer may have a front in-plane retardation of 100 nm, 101 nm, 102 nm, 103 nm, 104 nm, 105 nm, 106 nm, 107 nm, 108 nm, 109 nm, 110 nm, 111 nm, 112 nm, 113 nm, 114 nm, 115 nm, 116 nm, 117 nm, 118 nm, 119 nm, 120 nm, 121 nm, 122 nm, 123 nm, 124 nm, 125 nm, 126 nm, 127 nm, 128 nm, 129 nm, 130 nm, 131 nm, 132 nm, 133 nm, 134 nm, 135 nm, 136 nm, 137 nm, 138 nm, 139 nm, or 140 nm, at a wavelength of 550 nm. Preferably, the positive A layer has a front in-plane retardation of 110 nm to 130 nm at a wavelength of 550 nm.

The positive A layer can exhibit positive wavelength dispersion characteristics. Herein, the positive wavelength dispersion characteristics mean that in-plane retardation gradually decreases with increasing wavelength. In one embodiment, the positive A layer may have an Re(450)/Re(550) value of greater than 1, for example, 1.01 to 1.5, and an Re(650)/Re(550) value of less than 1, for example, 0.8 to 0.99.

The positive A layer may have an out-of-plane retardation of 50 nm to 70 nm, for example, 50 nm, 51 nm, 52 nm, 53 nm, 54 nm, 55 nm, 56 nm, 57 nm, 58 nm, 59 nm, 60 nm, 61 nm, 62 nm, 63 nm, 64 nm, 65 nm, 66 nm, 67 nm, 68 nm, 69 nm, or 70 nm, specifically 55 nm to 65 nm, at a wavelength of 550 nm. Within this range, the effects of the present invention can be easily realized.

The positive A layer may have a degree of biaxiality of 0.9 to 1.1, for example, 0.9, 0.91, 0.92, 0.93, 0.94, 0.95, 0.96, 0.97, 0.98, 0.99, 1, 1.01, 1.02, 1.03, 1.04, 1.05, 1.06, 1.07, 1.08, 1.09, or 1.1, specifically 0.95 to 1.05, at a wavelength of 550 nm. Within this range, the effects of the present invention can be easily realized.

The positive A layer may have a slow axis and a fast axis in an in-plane direction thereof, in which the slow axis of the positive A layer may be slanted at an angle of 70° to 85°, for example, 70°, 71°, 72°, 73°, 74°, 75°, 76°, 77°, 78°, 79°, 80°, 81°, 82°, 83°, 84°, or 85°, preferably 75° to 80°, with respect to the light transmission axis of the polarizer. Within this range, the effects of the present invention can be easily realized.

The positive A layer may have a thickness of 1.0 μm to 3.0 μm, specifically 1.0 μm to 2.0 μm. Within this range, the polarizing plate can achieve thickness reduction.

Although the positive A layer may be a non-liquid crystal layer, the positive A layer is preferably a liquid crystal layer to achieve thickness reduction of the polarizing plate. In one embodiment, the positive A layer may be a nematic liquid crystal layer.

The nematic liquid crystal layer may be formed of a composition realizing nematic liquid crystals. The composition may include a polymerizable compound.

The polymerizable compound may have at least one polymerizable crosslinking group. For example, the polymerizable crosslinking group may include an acrylate group, a methacrylate group, a vinyl group, a vinyl oxy group, an epoxy group, an oxetane group, a thiol group, a maleimide group, or derivatives thereof. Specifically, the polymerizable crosslinking group may include at least one selected from Formulas R-1 to R-15:

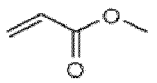
(R-1)

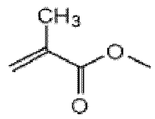
(R-2)

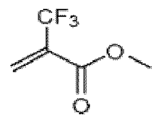
(R-3)

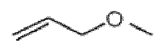
(R-4)

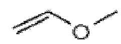
(R-5)

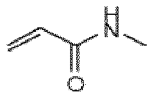
(R-6)

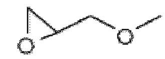
(R-7)

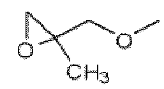
(R-8)

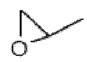
(R-9)

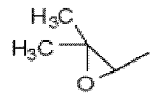
(R-10)

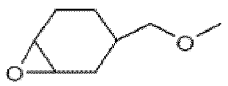
(R-11)

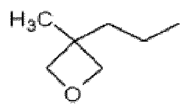
(R-12)

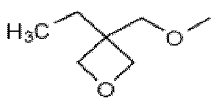
(R-13)

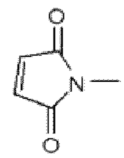
(R14)

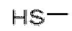
(R-15)

The composition may further include a liquid crystal compound. Although the liquid crystal compound does not have a polymerizable crosslinking group, the liquid crystal compound can impart liquid crystallinity to the composition upon curing of the composition.

The composition may further include typical additives, for example, a photo initiator, a surface regulator, an antioxidant, and the like, which are used in realization of the liquid crystal layer. The composition may include a solvent to facilitate formation of a liquid crystal layer having a uniform surface.

The negative A layer is a retardation layer satisfying a refractivity relation: nz ≒ nx > ny.

The negative A layer may exhibit positive wavelength dispersion characteristics. Here, the positive wavelength dispersion characteristics mean that the in-plane retardation decreases with increasing wavelength. In one embodiment, the negative A layer may have an Re(450)/Re(550) value of greater than 1, for example, 1.01 to 1.5, and an Re(650)/Re(550) value of less than 1, for example, 0.8 to 0.99.

In one embodiment, the negative A layer may have a front in-plane retardation of 200 nm to 280 nm at a wavelength of 550 nm. Within this range, the negative A layer allows the polarizing plate to easily achieve a maximum reflectivity of less than 2.5% at the lateral side together with the positive A layer and the negative C. In one embodiment, the negative A layer may have a front in-plane retardation of 200 nm, 201 nm, 202 nm, 203 nm, 204 nm, 205 nm, 206 nm, 207 nm, 208 nm, 209 nm, 210 nm, 211 nm, 212 nm, 213 nm, 214 nm, 215 nm, 216 nm, 217 nm, 218 nm, 219 nm, 220 nm, 221 nm, 222 nm, 223 nm, 224 nm, 225 nm, 226 nm, 227 nm, 228 nm, 229 nm, 230 nm, 231 nm, 232 nm, 233 nm, 234 nm, 235 nm, 236 nm, 237 nm, 238 nm, 239 nm, 240 nm, 241 nm, 242 nm, 243 nm, 244 nm, 245 nm, 246 nm, 247 nm, 248 nm, 249 nm, 250 nm, 251 nm, 252 nm, 253 nm, 254 nm, 255 nm, 256 nm, 257 nm, 258 nm, 259 nm, 260 nm, 261 nm, 262 nm, 263

nm, 264 nm, 265 nm, 266 nm, 267 nm, 268 nm, 269 nm, 270 nm, 271 nm, 272 nm, 273 nm, 274 nm, 275 nm, 276 nm, 277 nm, 278 nm, 279 nm, or 280 nm. Preferably, the negative A layer has a front in-plane retardation of 220 nm to 280 nm at a wavelength of 550 nm.

The negative A layer may have an out-of-plane retardation of -140 to -100 nm, for example, -140 nm, -139 nm, -138 nm, -137 nm, -136 nm, -135 nm, -134 nm, -133 nm, -132 nm, -131 nm, -130 nm, -129 nm, -128 nm, -127 nm, -126 nm, -125 nm, -124 nm, -123 nm, -122 nm, -121 nm, -120 nm, -119 nm, -118 nm, -117 nm, -116 nm, -115 nm, -114 nm, -113 nm, -112 nm, -111 nm, -110 nm, -109 nm, -108 nm, -107 nm, -106 nm, -105 nm, -104 nm, -103 nm, -102 nm, -101 nm, or -100 nm, specifically -130 nm to -110 nm, at a wavelength of 550 nm. Within this range, the effects of the present invention can be easily realized.

The negative A layer may have a degree of biaxiality of -0.1 to 0.1, for example, - 0.1, -0.09, -0.08, -0.07, -0.06, -0.05, -0.04, -0.03, -0.02, -0.01, 0, 0.01, 0.02, 0.03, 0.04, 0.05, 0.06, 0.07, 0.08, 0.09, or 0.1, specifically -0.05 to 0.05, at a wavelength of 550 nm. Within this range, the effects of the present invention can be easily realized.

The negative A layer may have a slow axis and a fast axis in the in-plane direction thereof, in which the slow axis of the negative A layer may be slanted at an angle of 10° to 25°, for example, 10°, 11°, 12°, 13°, 14°, 15°, 16°, 17°, 18°, 19°, 20°, 21°, 22°, 23°, 24°, or 25°, preferably 15° to 20°, with respect to the light transmission axis of the polarizer. Within this range, the effects of the present invention can be easily realized.

An angle defined between the slow axis of the positive A layer and the slow axis of the negative A layer may be in the range of 55° to 65°, for example, 55°, 56°, 57°, 58°, 59°, 60°, 61°, 62°, 63°, 64°, or 65°, preferably 57° to 63°. Within this range, the effects of the present invention can be easily realized.

The negative A layer may have a thickness of 1.0 μm to 5.0 μm, specifically 2.0 μm to 4.0 μm. Within this range, the polarizing plate can achieve thickness reduction.

Although the negative A layer may be a non-liquid crystal layer, the negative A layer is preferably a liquid crystal layer to achieve thickness reduction of the polarizing plate. In one embodiment, the negative A layer may be a discotic liquid crystal layer.

The discotic liquid crystal layer may be formed of a composition realizing discotic liquid crystals. The composition may include a polymerizable compound.

The polymerizable compound may have at least one polymerizable crosslinking group. For example, the polymerizable crosslinking group may be an acrylate group, a methacrylate group, a vinyl group, a vinyl oxy group, an epoxy group, an oxetane group, a thiol group, a maleimide group, or derivatives thereof. Specifically, the polymerizable crosslinking group may include at least one selected from Formulas R-1 to R-15:

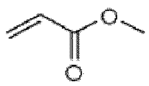
(R-1)

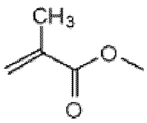
(R-2)

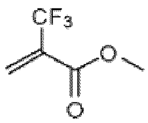
(R-3)

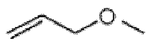
(R-4)

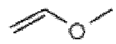
(R-5)

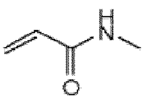
(R-6)

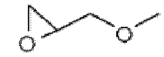
(R-7)

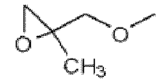
(R-8)

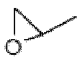
(R-9)

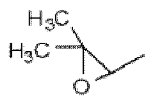
(R-10)

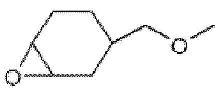
(R-11)

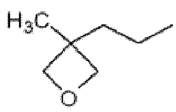
(R-12)

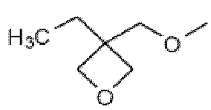
(R-13)

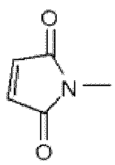
(R14)

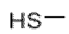
(R-15)

The composition may further include a liquid crystal compound. Although the liquid crystal compound does not have a polymerizable crosslinking group, the liquid crystal compound can impart liquid crystallinity to the composition upon curing of the composition.

The composition may further include typical additives, for example, a photo initiator, a surface regulator, an antioxidant, and the like, which are used in realization of the liquid crystal layer. The composition may include a solvent to facilitate formation of a liquid crystal layer having a uniform surface.

A laminate of the positive A layer and the negative A layer including an interlayer adhesive or a bonding agent between the positive A layer and the negative A layer may have a thickness of 2.0 μm to 13.0 μm, preferably 4.0 to 11.0 μm. Within this range, the laminate can realize thickness reduction of the polarizing plate.

The laminate of the positive A layer and the negative A layer may be formed by bonding the positive A layer to the negative A layer via an adhesive layer or a bonding layer. Alternatively, the laminate of the positive A layer and the negative A layer may be formed by coating the composition for the positive A layer on one surface of the negative A layer, followed by drying and/or curing. In this case, the positive A layer may be formed on the negative A layer by direct coating without the adhesive layer or the bonding layer.

The laminate of the positive A layer and the negative A layer may further include at least one first protective layer. The first protective layer may provide an additional function to the laminate and/or the polarizing plate. For example, the first protective layer complements the thickness of the laminate to improve durability and mechanical strength of the laminate. Alternatively, when at least one of the positive A layer and the negative A layer is the liquid crystal layer, the first protective layer may be a base film for formation of the liquid crystal layer.

The first protective layer is an optically transparent film and may be formed of at least one resin selected from among, for example, cellulose based resins including triacetylcellulose (TAC) and the like, polyester based resins including polyethylene terephthalate, polybutylene terephthalate, polyethylene naphthalate, polybutylene naphthalate, and the like, cyclic olefin polymer (COP) based resins, cyclic olefin copolymer (COC) based resins, polycarbonate based resins, polyether sulfone based resins, polysulfone based resins, polyamide based resins, polyimide based resins, polyolefin based resins, polyarylate based resins, polyvinyl alcohol based resins, polyvinyl chloride based resins, and polyvinylidene chloride based resins.

In one embodiment, the first protective layer may have a front in-plane retardation of 10 nm or less, for example, 0 nm to 5 nm, at a wavelength of 550 nm. Within this range, the first protective layer does not affect the effect of the laminate reducing reflectivity at a lateral side.

For the polarizing plate including only the laminate of the negative A layer and the positive A layer as the retardation layer, it can be difficult to achieve a reflectivity of less than 2.5% at the lateral side. In particular, when each of the negative A layer and the positive A layer is a liquid crystal layer, iodine can be eluted from the polarizer when the polarizing plate is left under high temperature/humidity conditions for a long period of time, thereby causing contamination of the liquid crystal layer and the panel. As described below, the negative C layer exhibiting out-of-plane retardation at a wavelength of 550 nm is stacked between the laminate of the negative A layer and the positive A layer and the polarizer to allow the polarizing plate to easily achieve a reflectivity of less than 2.5% at the lateral side and to prevent contamination of the liquid crystal layer and the panel due to elution of iodine from the polarizer even when the polarizing plate is left under high temperature/humidity conditions for a long period of time.

## Negative C layer

The negative C layer has an out-of-plane retardation of 20 nm to 60 nm at a wavelength of 550 nm. Within this range, the negative C layer can be interposed between the polarizer and the negative A layer to allow the polarizing plate to achieve a maximum reflectivity of less than 2.5% at a lateral side. Preferably, the negative C layer has an out-of-plane retardation of 30 nm to 40 nm.

In particular, the negative C layer having an out-of-plane retardation of 20 nm to 60 nm at a wavelength of 550 nm allows the polarizing plate to easily achieve a maximum reflectivity of less than 2.5% at the lateral side when the laminate of the positive A layer and the negative A layer has a linear retardation ($R_L$) of 120 nm to 180 nm, preferably 130 nm to 170 nm, at a wavelength of 550 nm, as calculated according to Equation E.

FIG. 3 is a graph depicting the maximum reflectivity (Y axis, unit: %) at a lateral side (60°) according to Rth of the negative C layer (X axis, unit: nm).

Referring to FIG. 3, it can be confirmed that, when the negative C layer has an out-of-plane retardation of 20 nm to 60 nm at a wavelength of 550 nm, the polarizing plate can achieve a maximum reflectivity of less than 2.5% at the lateral side. Conversely, it can be confirmed that, when the negative C layer has an out-of-plane retardation of less than 20 nm or greater than 60 nm at a wavelength of 550 nm, the polarizing plate cannot achieve a maximum reflectivity of less than 2.5% at the lateral side. In particular, when the negative C layer has an out-of-plane retardation of 20 nm at a wavelength of 550 nm, the maximum reflectivity of the polarizing plate at the lateral side is remarkably reduced, as compared to the maximum reflectivity of the polarizing plate when the negative C layer has an out-of-plane retardation of 10 nm at a wavelength of 550 nm 10 nm. Further, when the negative C layer has an out-of-plane retardation of 60 nm at a wavelength of 550 nm, the maximum reflectivity of the polarizing plate at the lateral side is remarkably reduced, as compared to the maximum reflectivity of the polarizing plate when the negative C layer has an out-of-plane retardation of 70 nm.

The negative C layer has a front in-plane retardation of 0 nm to 10 nm, for example, 0 nm, 1 nm, 2 nm, 3 nm, 4 nm, 5 nm, 6 nm, 7 nm, 8 nm, 9 nm, or 10 nm, preferably 0 to 5 nm, at a wavelength of 550 nm. Within this range, the effects of the present invention can be easily realized.

The negative C layer is a retardation layer satisfying a refractivity relation: nx ≒ ny > nz.

In one embodiment, the negative C layer may have a ratio of 0.0005 to 0.003 nm/nm, as calculated according to Equation 1. Within this range, the negative C layer allows the polarizing plate to easily achieve a reflectivity of less than 2.5% at the lateral side. For example, the negative C layer may have a ratio of 0.0005 nm/nm, 0.0006 nm/nm, 0.0007 nm/nm, 0.0008 nm/nm, 0.0009 nm/nm, 0.001 nm/nm, 0.0011 nm/nm, 0.0012 nm/nm, 0.0013 nm/nm, 0.0014 nm/nm, 0.0015 nm/nm, 0.0016 nm/nm, 0.0017 nm/nm, 0.0018 nm/nm, 0.0019 nm/nm, 0.002 nm/nm, 0.0021 nm/nm, 0.0021 nm/nm, 0.0022 nm/nm, 0.0023 nm/nm, 0.0024 nm/nm, 0.0025 nm/nm, 0.0026 nm/nm, 0.0027 nm/nm, 0.0028 nm/nm, 0.0029 nm/nm, or 0.003 nm/nm, as calculated according to Equation 1. Preferably, the negative C layer has a ratio of 0.001 nm/nm to 0.003 nm/nm, preferably 0.0015 nm/nm to 0.003 nm/nm, as calculated according to Equation 1. Within this range, the negative C layer allows the polarizing plate to easily achieve a reflectivity of less than 2.5% at the lateral side and can effectively prevent elution of iodine when the polarizing plate is left under high temperature/humidity conditions for a long period of time.

[Equation 1]

$$A / B,$$

where A is an out-of-plane retardation (unit: nm) of the negative C layer at a wavelength of 550 nm and B is a thickness (unit: nm) of the negative C layer.

In one embodiment, the negative C layer has a water vapor transmission rate of 400 $g/m^2 \cdot day$ or less, for example, 0, 10, 20, 30, 40, 50, 60, 70, 80, 90, 100, 150, 200, 250, 300, 350, or 400 $g/m^2 \cdot day$, for example, 0 to 400 $g/m^2 \cdot day$, specifically 0 to 300 $g/m^2 \cdot day$. Within this range, the negative C layer can prevent contamination of the liquid crystal layer and the panel due to elution of iodine from the polarizer even when the polarizing plate is left under high temperature/-humidity conditions for a long period of time.

The negative C layer may have a thickness of 10 μm to 80 μm, for example, 10 μm, 15 μm, 20 μm, 25 μm, 30 μm, 35 μm, 40 μm, 45 μm, 50 μm, 55 μm, 60 μm, 65 μm, 70 μm, 75 μm, or 80 μm, preferably 20 μm to 80 μm, more preferably 20 μm to 40 μm. Within this range, the negative C layer can be used in the polarizing plate.

The negative C layer may be formed of any material so long as the negative C layer can satisfy the out-of-plane retardation at a wavelength of 550 nm, the ratio of Equation 1 and the water vapor transmission rate set forth above. In one embodiment, the negative C layer may be a non-liquid crystal layer.

Preferably, the negative C layer is a film or coating layer including a polymer exhibiting positive inherent birefringence. Here, positive inherent birefringence means that the index of refraction increases in the machine direction (MD).

In one embodiment, the negative C layer may be formed of a cellulose resin including triacetylcellulose (TAC) and the like, or a norbornene resin including a cyclic olefin polymer (COP), a cyclic olefin copolymer (COC), and the like.

The negative C layer may be directly formed on the polarizer without an adhesive layer or a bonding layer therebetween, or may be bonded to the polarizer via the adhesive layer or the bonding layer therebetween.

The negative C layer may be formed using a composition including a polymer exhibiting positive inherent birefringence by a solution casting method. In the solution casting method, the negative C layer may be formed by dissolving the polymer exhibiting positive inherent birefringence and an additive in a solvent, followed by casting the prepared solution onto a substrate. The negative C layer may be obtained after removal of the solvent. As a result, the negative C layer can easily reach the out-of-plane retardation at a wavelength of 550 nm and the ratio of Equation 1, as set forth above.

Alternatively, the negative C layer can easily reach the out-of-plane retardation at a wavelength of 550 nm and the ratio of Equation 1, as set forth above, by changing the degree of polymerization or substitution of a cellulose resin, for example, a cellulose ester.

A laminate of the negative C layer, the negative A layer and the positive A layer may have a thickness ratio of 95% or more, for example, 95%, 96%, 97%, 98%, 99%, 100%, or 98% to 100%, for example, 100%, of the thickness of the retardation layer stacked on the lower surface of the polarizer. Within this range, the polarizing plate can secure improvement in processability. Preferably, only the laminate of the negative C layer, the negative A layer and the positive A layer is stacked on the lower surface of the polarizer.

The laminate of the negative C layer, the negative A layer and the positive A layer may have a thickness ratio of 80% or more, for example, 80%, 85%, 90%, 95%, 100%, or 80% to 100%, of the total thickness of the retardation layers and the first protective layer stacked on the lower surface of the polarizer. Within this range, the polarizing plate can secure improvement in processability. Preferably, only the laminate of the negative C layer, the negative A layer and the positive A layer is stacked on the lower surface of the polarizer.

The polarizing plate may further include a second protective layer on an upper surface of the polarizer. The second protective layer may be stacked singularly or in plural on the upper surface of the polarizer.

## Second protective layer

The second protective layer serves to protect the polarizer from external environments while improving mechanical strength of the polarizing plate. The second protective layer may include a protective film and/or a protective coating layer.

In one embodiment, the second protective layer is an optically transparent film and may be formed of at least one resin selected from among, for example, cellulose based resins including triacetylcellulose (TAC) and the like, polyester based resins including polyethylene terephthalate (PET), polybutylene terephthalate, polyethylene naphthalate, polybutylene naphthalate (PEN), and the like, cyclic olefin polymer (COP) based resins, cyclic olefin copolymer (COC) based resins, polycarbonate based resins, polyether sulfone based resins, polysulfone based resins, polyamide based resins, polyimide based resins, polyolefin based resins, polyarylate based resins, polyvinyl alcohol based resins, polyvinyl chloride based resins, and polyvinylidene chloride based resins.

The polarizing plate may further include a functional coating layer on at least one surface of the second protective layer. For example, the functional coating layer may include an antireflection layer, a low reflectivity layer, a hard coating layer, an anti-fingerprint layer, an anti-glare layer, a primer layer, and the like.

The second protective layer may have a thickness of 5 $\mu$m to 70 $\mu$m, specifically 15 $\mu$m to 45 $\mu$m. Within this range, the second protective layer can be used in the polarizing plate.

FIG. 1 and FIG. 2 are sectional views of polarizing plates according to embodiments of the present invention.

Referring to FIG. 1, the polarizing plate may include: a polarizer 30; and a negative C layer 10, a negative A layer 20, and a positive A layer 40 sequentially stacked on a lower surface of the polarizer 30. Referring to FIG. 2, the polarizing plate may include: a polarizer 30; a negative C layer 10, a negative A layer 20, and a positive A layer 40 sequentially stacked on a lower surface of the polarizer 30; and a second protective layer 50 stacked on an upper surface of the polarizer 30.

An optical display apparatus includes the polarizing plate according to the present invention. The optical display apparatus may include an organic light emitting diode (OLED) display apparatus and a liquid crystal display apparatus.

In one embodiment, the OLED display apparatus may include an organic light emitting diode panel including a flexible substrate, and the polarizing plate according to the present invention stacked on the organic light emitting diode panel.

In another embodiment, the OLED display apparatus may include an organic light emitting diode panel including a non-flexible substrate, and the polarizing plate according to the present invention stacked on the organic light emitting diode panel.

[Mode for Invention]

Next, the present invention will be described in more detail with reference to examples. However, it should be understood that these examples are provided for illustration only and should not be construed in any way as limiting the invention.

### Example 1

A polarizer having a total light transmittance of 45% was prepared by stretching a polyvinyl alcohol film (PS#60, pre-stretching thickness: 60 $\mu$m, Nippon Kuraray Co., Ltd.) to 6 times an initial thickness thereof in an aqueous iodine solution at 55°C in the machine direction thereof.

A positive A layer (QLAA218, FUJI Co., Ltd.), a negative A layer (QLAB218, FUJI Co., Ltd.), and a negative C layer (SDI Co., Ltd.) were prepared.

A polarizing plate including a laminate of a TAC film, the polarizer, the negative C layer, the negative A layer and the positive A layer was prepared by sequentially stacking the negative C layer, the negative A layer and the positive A layer on a lower surface of the polarizer via adhesives, followed by bonding the TAC film (KC4UX, KONICA Co., Ltd.) to an upper surface of the polarizer.

The positive A layer exhibited positive wavelength dispersion characteristics and was a nematic liquid crystal layer. In addition, the positive A layer had a front in-plane retardation of 120 nm and an out-of-plane retardation of 60 nm at a wavelength of 550 nm, and a degree of biaxiality of 1; and the slow axis of the positive A layer was slanted at an angle of 77.5° with respect to the light transmission axis of the polarizer.

The negative A layer exhibited positive wavelength dispersion characteristics and was a discotic liquid crystal layer. In addition, the negative A layer had a front in-plane retardation of 240 nm and an out-of-plane retardation of -120 nm at a wavelength of 550 nm, and a degree of biaxiality of 0; and the slow axis of the negative A layer was slanted at an angle of 17.5° with respect to the light transmission axis of the polarizer.

A laminate of the positive A layer and the negative A layer exhibited negative wavelength dispersion characteristics and had an in-plane retardation $R_L$ of 151.5 nm at a wavelength of 550 nm.

The negative C layer was a non-liquid crystal layer and was formed of a cyclic olefin copolymer (COC) film. The negative C layer had a front in-plane retardation of 0 nm and an out-of-plane retardation of 40 nm at a wavelength of 550 nm, a water vapor transmission rate of 35 g/$m^2$/day, and a ratio of 0.002 nm/nm according to Equation 1.

**Examples 2 to 4**

Polarizing plates were prepared in the same manner as in Example 1 except that a cyclic olefin copolymer (COC) film was used as the negative C layer, and the negative C layer having specification as listed in Table 1 was prepared through adjustment in drying temperature and/or flow rate and/or thickness in preparation of the COC film.

**Examples 5 and 6**

Polarizing plates were prepared in the same manner as in Example 1 except that a triacetylcellulose (TAC) film corresponding to a non-liquid crystal layer was used as the negative C layer, and the negative C layer having specifications as listed in Table 1 was prepared through adjustment in drying temperature and/or flow rate and/or thickness in preparation of the TAC film.

**Comparative Example 1**

A polarizing plate was prepared in the same manner as in Example 1 except that a TAC film, a polarizer, a negative A layer, and a positive A layer were sequentially stacked without a negative C layer.

**Comparative Examples 2 and 4 to** 7

Polarizing plates were prepared in the same manner as in Example 1 except that a cyclic olefin copolymer (COC) film was used as the negative C layer, and the negative C layer having specifications as listed in Table 1 was prepared through adjustment in drying temperature and/or flow rate and/or thickness in preparation of the COC film.

**Comparative Example 3**

A polarizing plate was prepared in the same manner as in Example 1 except that a TAC film, a polarizer, a negative C layer, a positive A layer, and a negative A layer were sequentially stacked.

Re, Rth, and NZ of each of the retardation layers were measured at a wavelength of 550 nm using an AxoScan.

The polarizing plates prepared in Examples and Comparative Examples were evaluated as to the following properties and evaluation results are shown in Table 1.

(1) Prevention of iodine elution: The polarizing plates prepared in Examples and Comparative Examples were left in a chamber under high temperature/humidity conditions (60°C and 90% RH) for 250 hours and edge portions of the polarizing plates were observed through a microscope to compare the degrees of iodine elution. Complete color change of the polarizing plate into a violet color due to iodine elution was rated as "poor (P)", slight color change of the polarizing plate into a violet color was rated as "good (G)", and no color change of the polarizing plate was rated as "very good (VG)".

(2) Maximum reflectivity at lateral side (incidence angle: 60°): Reflectivity of each of the polarizing plates prepared in Examples and Comparative Examples was measured in all directions excluding primary reflection through a simulation program Techwiz 1D (Sanai System, South Korea) to calculate the maximum reflectivity of each of the polarizing plates in a direction where reflectivity with respect to external light entering the polarizing plate became the maximum value.

Table 1

| | | Example | | | | | |
|---|---|---|---|---|---|---|---|
| | | 1 | 2 | 3 | 4 | 5 | 6 |
| Negative C layer | Re | 0 | 0 | 0 | 0 | 0 | 0 |
| | $R_{th}$ | 40 | 30 | 50 | 60 | 40 | 40 |
| | Thick ness ($\mu$m) | 20 | 20 | 20 | 20 | 60 | 80 |
| | Ratio of Eq. 1 | 0.002 | 0.001 5 | 0.002 5 | 0.003 | 0.00 067 | 0.000 5 |
| Prevention of iodine elution | | very good | very good | very good | very good | goo d | good |
| Maximum reflectivity @60° | | 2.30 | 2.33 | 2.34 | 2.45 | 2.3 | 2.3 |

Table 2

| | | Comparative Example | | | | | | |
|---|---|---|---|---|---|---|---|---|
| | | 1 | 2 | 3 | 4 | 5 | 6 | 7 |
| Negative C layer | Re | - | 0 | 0 | 0 | 0 | 0 | 0 |
| | $R_{th}$ | - | 10 | 20 | 70 | 80 | 90 | 100 |
| | Thick ness ($\mu$m) | - | 20 | 20 | 40 | 40 | 60 | 60 |
| | Ratio of Eq. 1 | - | 0.000 5 | 0.001 | 0.001 8 | 0.002 | 0.001 5 | 0.001 7 |
| Prevention of iodine elution | | Poor | very good | very good | very good | very good | very good | very good |
| Maximum reflectivity @60° | | 3.64 | 2.92 | 39.39 | 2.63 | 2.91 | 3.32 | 3.87 |

As shown in Table 1, the polarizing plates according to the present invention realized very low reflectivity, that is, a maximum reflectivity of less than 2.5%, and good black visibility at a lateral side, and minimized contamination of the liquid crystal layer and/or a panel due to elution of iodine from the polarizer even when left under high temperature/humidity conditions for a long period of time.

Conversely, as shown in Table 2, the polarizing plates of Comparative Examples suffered from contamination of the liquid crystal layer and/or a panel due to elution of iodine from the polarizer when left under high temperature/humidity conditions for a long period of time, and/or failed to provide very low reflectivity, that is, a maximum reflectivity of less than 2.5%, at a lateral side.

It should be understood that various modifications, changes, alterations, and equivalent embodiments can be made by those skilled in the art without departing from the spirit and scope of the invention.

## Claims

1. A polarizing plate comprising: a polarizer; and a retardation layer stacked on a lower surface of the polarizer, wherein the retardation layer comprises a negative C layer, a negative A layer and a positive A layer sequentially stacked on the lower surface of the polarizer, and the negative C layer has an out-of-plane retardation of 20 nm to 60 nm at a wavelength of 550 nm.

2. The polarizing plate according to claim 1, wherein the negative C layer has a front in-plane retardation of 0 nm to 10 nm at a wavelength of 550 nm.

3. The polarizing plate according to claim 1, wherein the negative C layer has a ratio of 0.0005 nm/nm to 0.003 nm/nm, as calculated according to Equation 1:

$$A / B, \qquad \text{----(1)}$$

where A is an out-of-plane retardation of the negative C layer at a wavelength of 550 nm and B is a thickness of the negative C layer, a unit of A is nm, and a unit of B is nm.

4. The polarizing plate according to claim 1, wherein the negative C layer has a water vapor transmission rate of 400 $g/m^2 \cdot day$ or less.

5. The polarizing plate according to claim 1, wherein the negative C layer is a film or coating layer comprising a polymer exhibiting positive inherent birefringence.

6. The polarizing plate according to claim 1, wherein the negative C layer is formed of a triacetylcellulose (TAC), cyclic olefin polymer (COP) or cyclic olefin copolymer (COC) resin.

7. The polarizing plate according to claim 1, wherein a thickness ratio of a laminate of the negative C layer, the negative A layer and the positive A layer to the retardation layer is 95% or more.

8. The polarizing plate according to claim 1, wherein a laminate of the negative A layer and the positive A layer has negative wavelength dispersion characteristics.

9. The polarizing plate according to claim 1, wherein a laminate of the negative A layer and the positive A layer has a linear retardation of 120 nm to 180 nm at a wavelength of 550 nm.

10. The polarizing plate according to claim 1, wherein the positive A layer has a lower front in-plane retardation at a wavelength of 550 nm than the negative A layer.

11. The polarizing plate according to claim 10, wherein the positive A layer has a front in-plane retardation of 100 nm to 140 nm at a wavelength of 550 nm and the negative A layer has a front in-plane retardation of 200 nm to 280 nm at a wavelength of 550 nm.

12. The polarizing plate according to claim 1, wherein a slow axis of the positive A layer is slanted at an angle of 55° to 65° with respect to a slow axis of the negative A layer.

13. The polarizing plate according to claim 1, wherein a slow axis of the positive A layer is slanted at an angle of 70° to 85° with respect to a light transmission axis of the polarizer and a slow axis of the negative A layer is slanted at an angle of 10° to 25° with respect to the light transmission axis of the polarizer.

14. The polarizing plate according to claim 1, wherein each of the positive A layer and the negative A layer is a liquid crystal layer.

15. The polarizing plate according to claim 14, wherein the positive A layer is a nematic liquid crystal layer and the negative A layer is a discotic liquid crystal layer.

16. The polarizing plate according to claim 1, further comprising:
a second protective layer stacked on an upper surface of the polarizer.

17. An optical display apparatus comprising the polarizing plate according to any one of claims 1 to 16.

FIG. 1

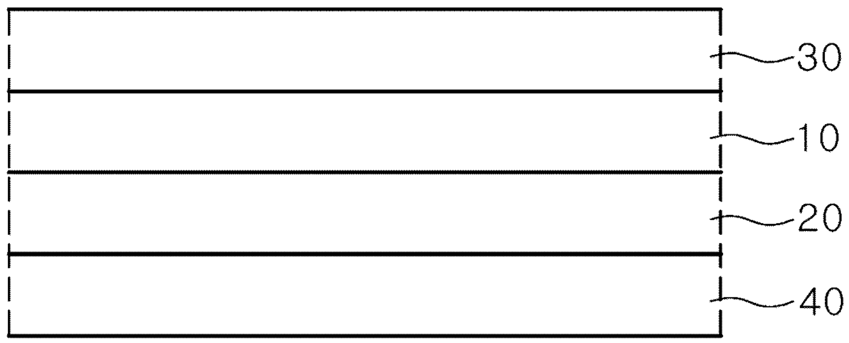


FIG. 2

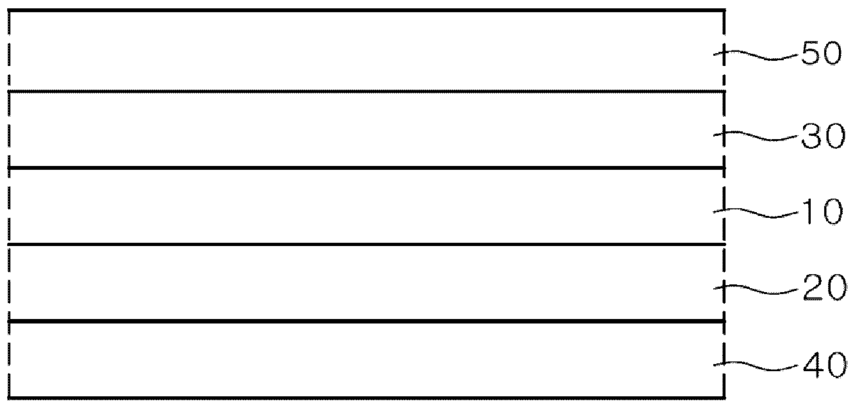

FIG. 3

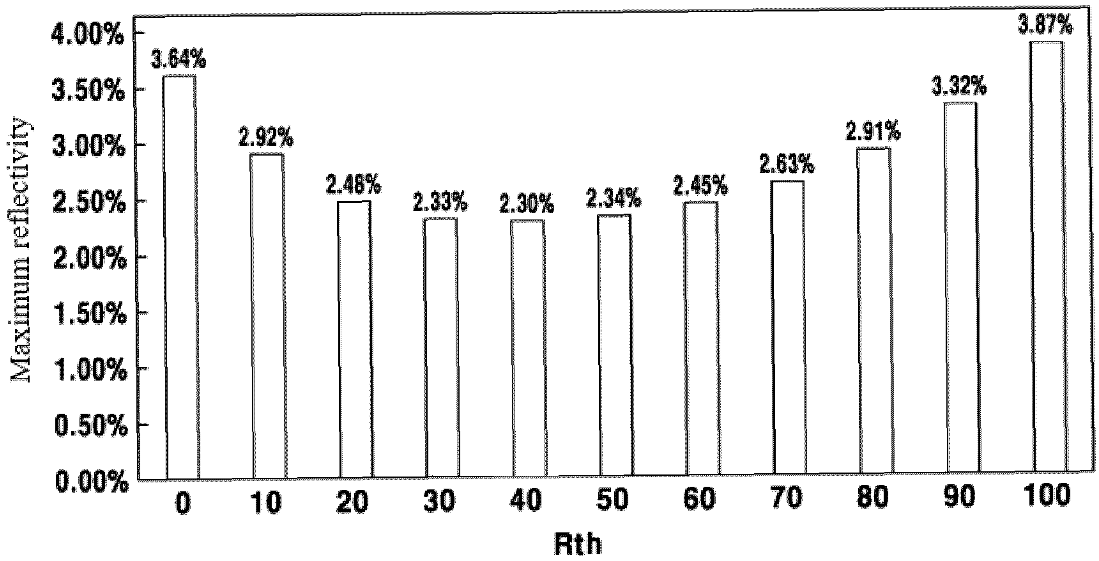
4.00%
3.50%
3.00%
2.50%
2.00%
1.50%
1.00%
0.50%
0.00%
Maximum reflectivity
3.64%
2.92%
2.48%
2.33%
2.30%
2.34%
2.45%
2.63%
2.91%
3.32%
3.87%
0
10
20
30
40
50
60
70
80
90
100
Rth

## INTERNATIONAL SEARCH REPORT

International application No.
**PCT/KR2023/019967**

### A. CLASSIFICATION OF SUBJECT MATTER

**G02B 5/30**(2006.01)i; **G02B 1/14**(2015.01)i; **G02B 1/18**(2015.01)i; **G02B 1/11**(2006.01)i; **H10K 59/50**(2023.01)i; **B29C 55/04**(2006.01)i; **G02F 1/1335**(2006.01)i

According to International Patent Classification (IPC) or to both national classification and IPC

### B. FIELDS SEARCHED

Minimum documentation searched (classification system followed by classification symbols)

G02B 5/30(2006.01); C08F 32/00(2006.01); C08J 5/18(2006.01); G02B 5/20(2006.01); G02F 1/1335(2006.01); G02F 1/13363(2006.01); H01L 51/52(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 편광자(polarizer), 위상차(retardation), 포지티브(positive), 네가티브(negative), 파장(wavelength)

### C. DOCUMENTS CONSIDERED TO BE RELEVANT

| Category* | Citation of document, with indication, where appropriate, of the relevant passages | Relevant to claim No. |
|---|---|---|
| Y | CN 115437055 A (FUJIFILM CORPORATION) 06 December 2022 (2022-12-06)<br>See paragraph [0301], claim 1 and figure 6. | 1-17 |
| Y | KR 10-2021-0023002 A (SAMSUNG SDI CO., LTD.) 04 March 2021 (2021-03-04)<br>See paragraphs [0199]-[0203], claims 1-11 and figure 3. | 1-17 |
| Y | KR 10-2020-0092159 A (SAMSUNG SDI CO., LTD.) 03 August 2020 (2020-08-03)<br>See paragraphs [0135]-[0138]. | 2-3 |
| Y | KR 10-2008-0046572 A (LG CHEM, LTD.) 27 May 2008 (2008-05-27)<br>See claim 1. | 5 |
| Y | KR 10-2011-0031537 A (DONGWOO FINE-CHEM CO., LTD.) 29 March 2011 (2011-03-29)<br>See claim 1. | 6 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **26 March 2024** | **26 March 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.
**PCT/KR2023/019967**

**C. DOCUMENTS CONSIDERED TO BE RELEVANT**

| Category* | Citation of document, with indication, where appropriate, of the relevant passages | Relevant to claim No. |
|---|---|---|
| Y | KR 10-2020-0109190 A (SAMSUNG SDI CO., LTD.) 22 September 2020 (2020-09-22)<br>See claims 1, 9 and 12. | 8,10-11 |
| Y | KR 10-2017-0092737 A (SAMSUNG DISPLAY CO., LTD.) 14 August 2017 (2017-08-14)<br>See claims 5-8. | 14-15 |

Form PCT/ISA/210 (second sheet) (July 2022)

**INTERNATIONAL SEARCH REPORT**
**Information on patent family members**

International application No.
**PCT/KR2023/019967**

| Patent document cited in search report | | | Publication date (day/month/year) | Patent family member(s) | | | Publication date (day/month/year) |
|---|---|---|---|---|---|---|---|
| CN | 115437055 | A | 06 December 2022 | JP | 2022-184691 | A | 13 December 2022 |
| | | | | KR | 10-2022-0162622 | A | 08 December 2022 |
| | | | | US | 11550088 | B2 | 10 January 2023 |
| | | | | US | 2022-0397712 | A1 | 15 December 2022 |
| KR | 10-2021-0023002 | A | 04 March 2021 | CN | 114270232 | A | 01 April 2022 |
| | | | | TW | 202109087 | A | 01 March 2021 |
| | | | | TW | I750774 | B | 21 December 2021 |
| | | | | US | 2022-0299691 | A1 | 22 September 2022 |
| | | | | WO | 2021-034012 | A1 | 25 February 2021 |
| KR | 10-2020-0092159 | A | 03 August 2020 | WO | 2020-153639 | A1 | 30 July 2020 |
| KR | 10-2008-0046572 | A | 27 May 2008 | | None | | |
| KR | 10-2011-0031537 | A | 29 March 2011 | | None | | |
| KR | 10-2020-0109190 | A | 22 September 2020 | CN | 113474695 | A | 01 October 2021 |
| | | | | KR | 10-2022-0106940 | A | 01 August 2022 |
| | | | | KR | 10-2620956 | B1 | 03 January 2024 |
| | | | | TW | 202040239 | A | 01 November 2020 |
| | | | | TW | I744819 | B | 01 November 2021 |
| | | | | WO | 2020-184862 | A1 | 17 September 2020 |
| KR | 10-2017-0092737 | A | 14 August 2017 | US | 10181584 | B2 | 15 January 2019 |
| | | | | US | 2017-0222188 | A1 | 03 August 2017 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020130103595